# EUROPEAN PATENT APPLICATION

(11) **EP 4 848 954 A1**
(43) Date of publication of application: **02.12.2026**
(21) Application number: 25744904.1
(22) Date of filing: 15.01.2025
(51) Int. Cl.: H10K 30/50, H01L 21/368, H10K 30/40, H10K 71/13, H10K 71/40, H10K 85/50

(54) **PEROVSKITE FILM, THIN FILM SOLAR CELL, METHOD FOR PRODUCING PEROVSKITE FILM, AND METHOD FOR PRODUCING THIN FILM SOLAR CELL**

(30) Priority: 23.01.2024 JP 2024008315
(71) Applicant: National University Corporation Kanazawa University, Ishikawa 920-1192 (JP)
(72) Inventor: SHAHIDUZZAMAN Md., Kanazawa-shi, Ishikawa 920-1192 (JP); TAIMA Tetsuya, Kanazawa-shi, Ishikawa 920-1192 (JP); NAKAHARA Yugo, Kanazawa-shi, Ishikawa 920-1192 (JP); TAKAHASHI Kohshin, Kanazawa-shi, Ishikawa 920-1192 (JP); KOTANI Kozo, Ritto-shi, Shiga 520-3045 (JP); IKUHARA Shiro, Ritto-shi, Shiga 520-3045 (JP)
(74) Representative: Icosa
(86) International application number: PCT/JP2025/001019
(87) International publication number: WO 2025/158974

(57) **Abstract**

The perovskite film has a plurality of grains when viewed in plan from a stacking direction, and a modal grain size of the plurality of grains is 1 µm or more.

## Description

### TECHNICAL FIELD

The present disclosure relates to a perovskite film, a thin film solar cell, a method for producing a perovskite film, and a method for producing a thin film solar cell. Priority is claimed on Japanese Patent Application No. 2024-008315, filed January 23, 2024, the content of which is incorporated herein by reference.

### BACKGROUND ART

In recent years, thin film solar cells using a thin film having a perovskite structure have been developed. The perovskite structure is a cubic crystal structure represented by a general formula ABX₃. Different atoms or molecules are disposed at the vertices (A sites) of the cube, the centers (B sites) of each face of the cube, and the center (X site) of the cube. For example, an organic material such as CH₃NH₃⁺ or CH₅N₂⁺ is used for the A site.

The perovskite film is weak against water. Therefore, the perovskite film is required to be produced in an inert gas atmosphere or a dry atmosphere with a relative humidity of 20% or less, and the production cost is high. In addition, the perovskite film has low durability in air containing moisture, and the performance significantly deteriorates in about one month.

Patent Document 1 discloses that an ionic liquid is added to a precursor solution of a perovskite film, and the perovskite film is formed by spin coating. The perovskite film of Patent Document 1 has a film structure in which nanosized fine particles are aggregated.

### Citation List

### Patent Document

Patent Document 1: Japanese Patent No. 6501303

### SUMMARY OF INVENTION

### Technical Problem

The perovskite film is expected to be applied to various elements such as a photoelectric conversion element, a piezoelectric conversion element, and a thermoelectric conversion element, and further improvement of the performance and reduction of the production cost are required. In addition, a method for producing a perovskite film under normal atmospheric conditions is required, instead of a limited environment such as an inert gas. For example, as described in Patent Document 1, the perovskite film can be produced in air by adding an ionic liquid to a precursor solution. However, the production method disclosed in Patent Document 1 is not suitable for mass production, and further improvement of the durability of the produced perovskite film is required.

The present disclosure has been made in view of the above-described problems, and an object of the present disclosure is to provide a highly durable perovskite film, a thin film solar cell, and methods for producing the perovskite film and the thin film solar cell.

### Solution to Problem

To solve the above-described problems, the present disclosure provides the following means.

A perovskite film according to a first aspect has a plurality of grains when viewed in plan from a stacking direction, and a modal grain size of the plurality of grains is 1 µm or more.

### Advantageous Effects of Invention

The perovskite film and the thin film solar cell according to the present embodiment have high durability. The method for producing a perovskite film and the method for manufacturing a thin film solar cell according to the present embodiment can produce a perovskite film or a thin film solar cell at a low cost.

### BRIEF DESCRIPTION OF DRAWINGS

[FIG. 1] A scanning electron microscope (SEM) image of a perovskite film according to the present embodiment.
[FIG. 2] A schematic view of a characteristic portion of the perovskite film according to the present embodiment.
[FIG. 3] Water contact angles of a perovskite film according to the present embodiment and a perovskite film not having a hydrophobic functional group.
[FIG. 4] A flowchart of a method for producing a perovskite film according to the present embodiment.
[FIG. 5] A view for describing a mixed solution preparation step of the method for producing a perovskite film according to the present embodiment.
[FIG. 6] A view for describing a base layer preparation step of the method for producing a perovskite film according to the present embodiment.
[FIG. 7] A view for describing a coating step of the method for producing a perovskite film according to the present embodiment.
[FIG. 8] A view for describing a homogenization step of the method for producing a perovskite film according to the present embodiment.
[FIG. 9] Comparative images of a perovskite film subjected to a homogenization step and a perovskite film not been subjected to a homogenization step.
[FIG. 10] A view for describing an annealing step of the method for producing a perovskite film according to the present embodiment.
[FIG. 11] A scanning electron microscope (SEM) image of a perovskite film according to a first comparative example.
[FIG. 12] A schematic view for describing characteristics of a perovskite film according to the present embodiment.
[FIG. 13] A scanning electron microscope (SEM) image of a perovskite film according to a second comparative example.
[FIG. 14] A scanning electron microscope (SEM) image of a perovskite film according to a third comparative example.
[FIG. 15] A schematic view of a solar cell according to the present embodiment.
[FIG. 16] A schematic view for describing characteristics of a solar cell according to the present embodiment.
[FIG. 17] X-ray diffraction images of the first example and the second comparative example.
[FIG. 18] Characteristics of thin film solar cells using the perovskite films of the first example and the second comparative example.
[FIG. 19] Results of measuring durability of thin film solar cells using the perovskite films of the first example, the first comparative example, the second comparative example, and the third comparative example.
[FIG. 20] Output characteristics (PCE) of the thin film solar cells of the first example, the third example to the sixth example, and the second comparative example.

### DESCRIPTION OF EMBODIMENTS

Hereinafter, the present embodiment will be described in detail. The following description is an example of the present invention, and the present invention is not limited thereto and can be appropriately modified and implemented within a range that does not change the gist thereof.

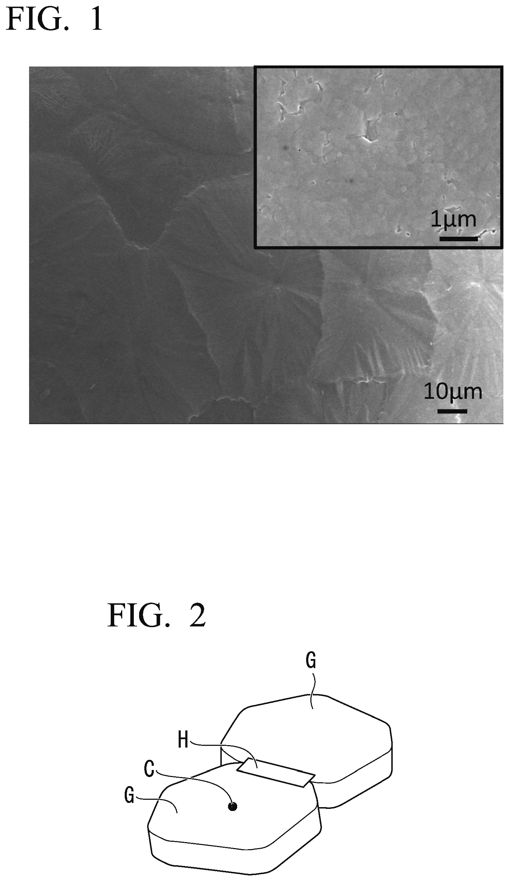

FIG. 1 is a scanning electron microscope (SEM) image of a perovskite film 10 according to the present embodiment. The perovskite film 10 according to the present embodiment has a plurality of grains in a plan view in a stacking direction. A modal grain size of the grains is 1 µm or more, preferably 2 µm or more, more preferably 10 µm or more, still more preferably 30 µm or more, and particularly preferably 50 µm or more. The modal grain size of the perovskite film shown in FIG. 1 is 70 µm.

The modal grain size is obtained by the following procedure. First, images at a magnification of 800 times are captured at three locations using a scanning electron microscope (SEM). Then, 10 grains are randomly extracted from each of the captured images. The major axis diameters of the extracted grains are measured. The measured major axis lengths of the grains are histogrammed, and the value with the highest frequency is defined as the modal grain size. In the histogramming in a case of obtaining the modal grain size, a graph is plotted with a horizontal axis as the major axis diameter of the grains and a vertical axis as the frequency, and the horizontal axis is divided into 1/10 of an average grain size to set the mode.

FIG. 2 is a diagram schematically showing a characteristic part of the perovskite film 10 according to the present embodiment. The perovskite film 10 may include a hydrophobic functional group H. The hydrophobic functional group H is present, for example, at least at grain boundaries of a plurality of grains G. In addition, the hydrophobic functional group H may be attached to the entire surface of the perovskite film 10.

The presence of the hydrophobic functional group H can be confirmed by a water contact angle measurement. In the water contact angle measurement, a water droplet is dropped onto the film surface, and a contact angle between the water droplet and the film is measured. In a case where the hydrophobic functional group H is present on the surface of the perovskite film 10, the water contact angle is 70° or more. The water contact angle of the perovskite film 10 is more preferably 75° or more.

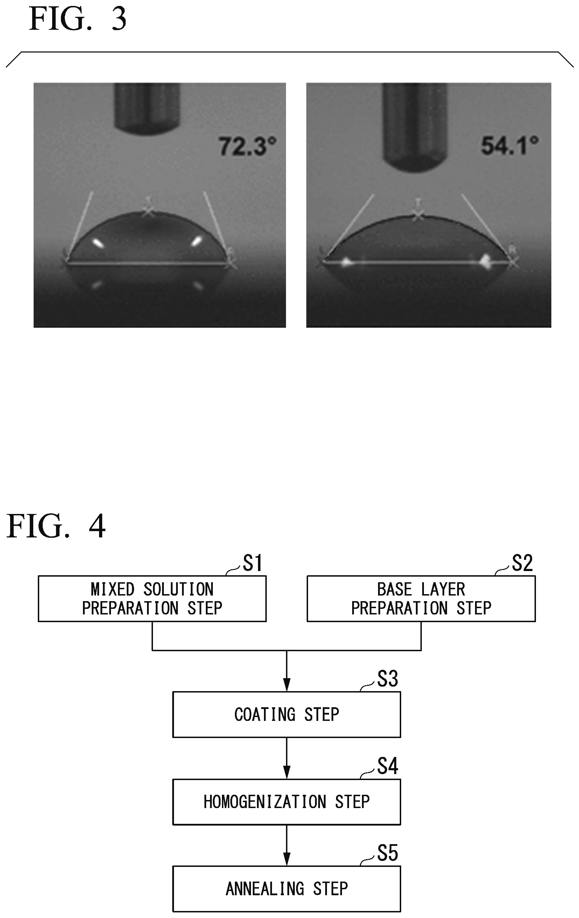

FIG. 3 shows water contact angles of the perovskite film according to the present embodiment and a perovskite film having no hydrophobic functional group. The left diagram of FIG. 3 shows measurement results of the water contact angle of the perovskite film according to the present embodiment in which an ionic liquid is used in the production of the perovskite film. The right diagram of FIG. 3 shows measurement results of the water contact angle of the perovskite film according to a comparative example in which an ionic liquid is not used in the production of the perovskite film. As shown in FIG. 3, the water contact angle of the perovskite film 10 according to the present embodiment having the hydrophobic functional group H is more than 70°, whereas the water contact angle of the perovskite film 10 according to the comparative example having no hydrophobic functional group H is about 50°.

The hydrophobic functional group H may be a hydrophobic group derived from a surfactant or a hydrophobic group derived from an ionic liquid. For example, the ionic liquid is bonded to the perovskite through an N-H bond. By the ionic liquid bonding to the perovskite film, the hydrophobic group of the ionic liquid is exposed on the surface of the perovskite film 10.

In addition, the perovskite film 10 according to the present embodiment has few holes that are confirmed in a case of being viewed in a plan view from the stacking direction. The holes are confirmed as black dots in a scanning electron microscope (SEM) image. The average density of the holes of the perovskite film 10 according to the present embodiment is, for example, 0.2 holes/µm² or less, preferably 1.0 holes/µm² or less, and more preferably 0.5 holes/µm² or less.

The average density of the holes is obtained by the following procedure. First, images at a magnification of 10,000 times are captured at three locations using a scanning electron microscope (SEM). Then, in each image, the number of holes is confirmed, and the number of holes is divided by the area of the image to obtain the density of the holes in each image. The average value of the densities of the holes obtained in each image is obtained to obtain the average density of the holes.

Next, a method for producing the perovskite film 10 according to the present embodiment will be described. FIG. 4 is a flowchart of a method for producing a perovskite film according to the present embodiment. The method for producing a perovskite film according to the present embodiment includes a mixed solution preparation step S1, a base layer preparation step S2, a coating step S3, a homogenization step S4, and an annealing step S5.

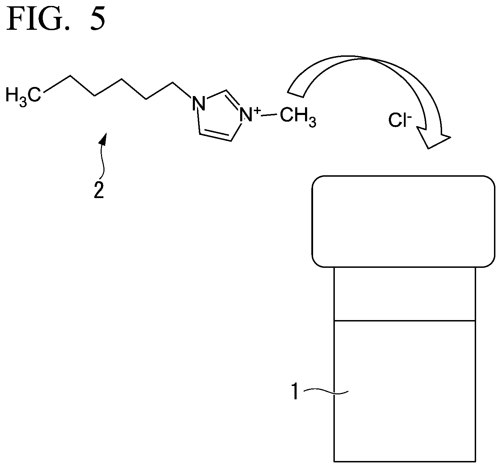

FIG. 5 is a diagram for describing the mixed solution preparation step S1 of the method for producing a perovskite film according to the present embodiment. In the mixed solution preparation step S1, the ionic liquid 2 is added to the perovskite precursor solution 1.

The perovskite precursor solution 1 contains a precursor material that generates a perovskite crystal. The perovskite precursor solution 1 contains, for example, an alkylammonium halide and a metal halide as the precursor material. The alkylammonium halide is, for example, CH₃NH₃I, CH₃NH₃Br, or CH₄N₂HI. The metal halide is, for example, PbI₂ or PbBr₂.

The solvent constituting the perovskite precursor solution 1 is, for example, an amide-based solvent, butyrolactone, or dimethyl sulfoxide (DMSO). The amide-based solvent is, for example, dimethylformamide (DMF), diethylformamide (DEF), diethylacetamide (DMAC), N-methylpyrrolidone (MPD), tetramethylurea (TMU), or hexamethylphosphoric triamide (HMPA).

The ionic liquid 2 is a salt that is liquid at a temperature of lower than 100°C, which is obtained by a combination of a cation and an anion. Since the ionic liquid is a liquid consisting of only ions, the ionic liquid has characteristics of strong electrostatic interaction, non-volatility, and non-flammability. The ionic liquid 2 is, for example, an imidazolium salt, a pyridinium salt, an ammonium salt, a pyrrolidinium salt, a phosphonium salt, or a sulfonium salt. The imidazolium cation forming the imidazolium salt is, for example, 1-hexyl-3-methylimidazolium, 1-butyl-3-methylimidazolium, 1-ethyl-2,3-dimethylimidazolium, or 1-dodecyl-3-methylimidazolium. The salt is, for example, a halide salt, a tetrafluoroborate salt, a hexafluorophosphate salt, an acetate, a hydrogen sulfate salt, an alkyl sulfate salt, a tosylate salt, or a methanesulfonate. The ionic liquid is, for example, 1-hexyl-3-methylimidazolium chloride (HMImCl) or 1-hexyl-3-methylimidazolium iodide (HMImI).

The ionic liquid 2 is added to the perovskite precursor solution 1 to obtain a mixed solution. The mass ratio of the ionic liquid 2 in the mixed solution is preferably 0.17 wt% or more and 0.83 wt% or less, more preferably 0.33 wt% or more and 0.66 wt% or less, and still more preferably 0.42 wt% or more and 0.58 wt% or less. In a case where the mass ratio of the ionic liquid 2 in the mixed solution is within the above-described range, when the perovskite structure is crystallized, crystals are suppressed from being refined, and a perovskite film having a large grain size can be obtained. For example, in a case where the concentration of the ionic liquid 2 contained in the mixed solution is high, the crystal nuclei may be micellized by the ionic liquid. On the other hand, in a case where the concentration of the ionic liquid 2 contained in the mixed solution is sufficiently low, the risk of the crystal growth of the fine particles being inhibited by the micellization is reduced.

In addition, the mixed solution may be prepared in several stages. For example, a solution to which the ionic liquid is added may be prepared as a first solution, a solution to which the ionic liquid is not added may be prepared as a second solution, and these solutions may be mixed to prepare the mixed solution. The first solution is, for example, a solution obtained by adding 1-hexyl-3-methylimidazolium chloride (HMImCl) as the ionic liquid to CH₃NH₃I and PbI₂. The solvent of the first solution is, for example, dimethylformamide. The second solution is, for example, a solution obtained by adding CH₄N₂HI, PbI₂, and PbBr₂ to a mixed solvent of dimethylformamide (DMF) and dimethyl sulfoxide (DMSO). The mass ratio of the ionic liquid in the first solution is, for example, preferably 1 wt% or more and 5 wt% or less, more preferably 2 wt% or more and 4 wt% or less, and still more preferably 2.5 wt% or more and 3.5 wt% or less.

In addition, any additive having a hydrophobic functional group may be used instead of the ionic liquid. As the additive, for example, phenethylammonium chloride (PEACl), potassium thiocyanate (KSCN), guanabenz acetate, L-α-phosphatidylcholine, or a tetradecyldimethyl(3-sulfopropyl)ammonium hydroxide intramolecular salt (TAH) can be used.

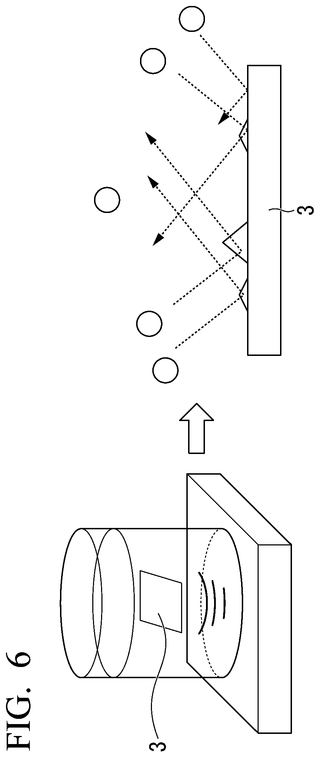

FIG. 6 is a schematic view for describing a base layer preparation step S2 of the method for producing a perovskite film according to the present embodiment. In the base layer preparation step S2, a substrate 3 having a base layer on which a perovskite film is to be formed is prepared. The base layer preparation step S2 is not an essential step, and may not be performed. For example, a commercially available substrate may be used as it is.

The substrate 3 having a base layer is, for example, glass on which a transparent conductive film is formed. The transparent conductive film is, for example, indium tin oxide (ITO), indium zinc oxide (IZO), zinc oxide, fluorine-doped tin oxide (FTO), or titanium oxide.

First, it is preferable to ultrasonically clean the substrate 3 having a base layer. In the ultrasonic cleaning, for example, ultrapure water cleaning, acetone cleaning, or ethanol cleaning is performed.

Next, the substrate 3 with a base layer is subjected to a plasma treatment. In the plasma treatment, the surface of the base layer of the substrate 3 is irradiated with oxygen plasma. When the base layer is subjected to a surface treatment, impurities adhering to the surface of the base layer are removed, and the activity of the surface of the base layer is increased. When the surface of the base layer is subjected to a plasma treatment, the wettability of the mixed solution with respect to the base layer is improved. The plasma treatment is performed, for example, at room temperature for 20 minutes under conditions of 115 V, 18 W, and a vacuum degree of 0.1 MPa.

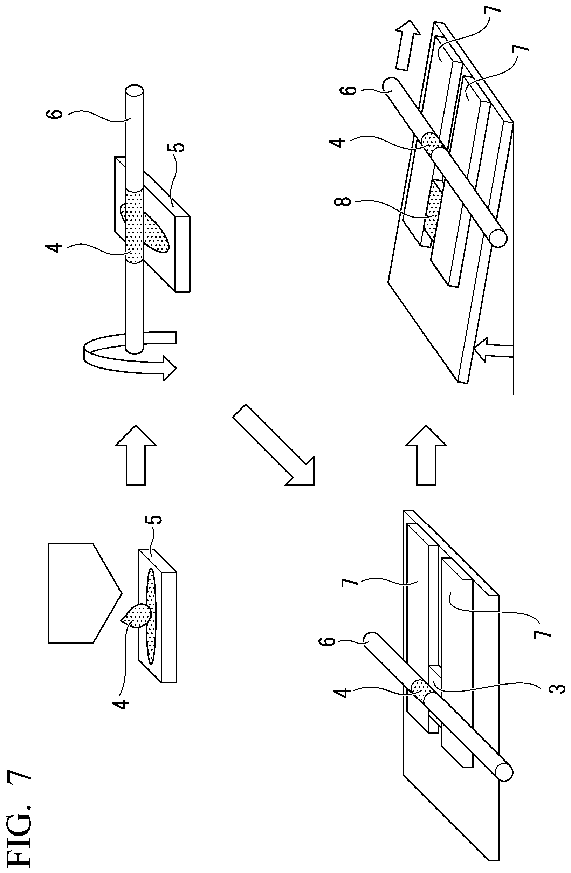

FIG. 7 is a schematic view for describing an example of a coating step S3 of the method for producing a perovskite film according to the present embodiment. In the coating step S3, the mixed solution 4 is applied onto the base layer by a predetermined coating method to form a coating film 8.

Here, the predetermined coating method is a bar coating method, blade coating, slot die coating, spray coating, gravure coating, reverse coating, or comma coating. When the coating film 8 is formed by these predetermined coating methods, the modal grain size of the grains G of the perovskite film 10 is increased. The reason for this is not clear, but it is considered that the grain growth of the grains G is promoted by gently removing the solvent, and the size of the grains G is increased. When a spin coating method in which the solvent is forcibly removed by rotation is used, the size of the grains G is reduced.

FIG. 7 is a specific example in a case where the predetermined coating method is a bar coating. First, the mixed solution 4 is added dropwise onto the dummy substrate 5. The dummy substrate 5 is not particularly limited. Next, a bar 6 is brought into contact with the mixed solution 4 added dropwise onto the dummy substrate 5 to attach the mixed solution 4 to the surface of the bar 6. Next, the bar 6 is installed on the substrate 3 with a base layer, which is an object to be coated. A support body 7 may be disposed on a side surface of the substrate 3 with a base layer such that the bar 6 does not tilt during the bar coating. Next, the bar 6 is moved in parallel with respect to the substrate 3 with a base layer. For example, when the device is inclined, the bar 6 rolls. Here, the bar 6 is moved by inclining the device, but the bar 6 may be simply moved in parallel. The mixed solution 4 attached to the bar 6 is attached to the surface of the base layer to form a coating film 8.

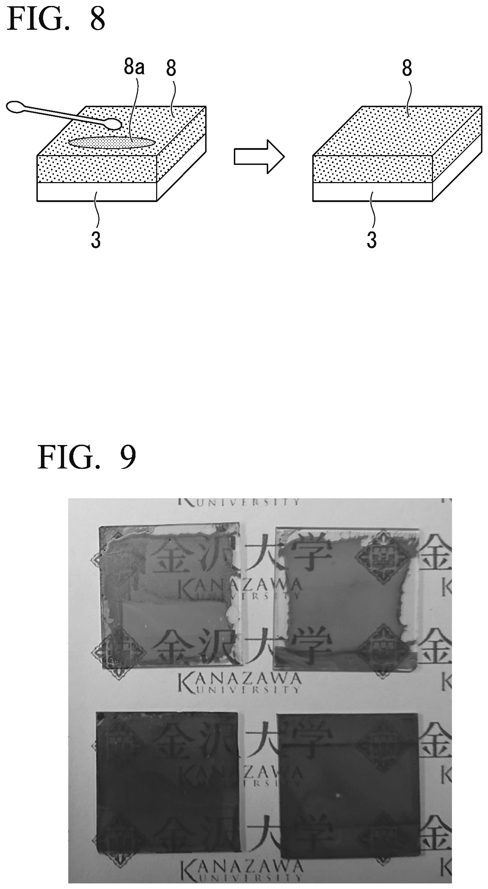

FIG. 8 is a schematic view for describing a homogenization step S4 of the method for producing a perovskite film according to the present embodiment. The homogenization step S4 is not an essential step, but is preferably performed. In the homogenization step S4, the coating film 8 is held for a certain period of time before being annealed. The holding for a certain period of time means that heating or the like is not performed in a state where a relative positional relationship of the coating film 8 with respect to the substrate 3 with a base layer is maintained, and the coating film 8 may move integrally with the substrate 3 with a base layer. The homogenization step is preferably performed for 5 minutes or longer, and more preferably performed for 5 minutes or longer and 10 minutes or less.

FIG. 9 is a comparative image of perovskite films in an example in which the homogenization step S4 was performed and an example in which the homogenization step S4 was not performed. In FIG. 9, the upper two samples are perovskite films in which the homogenization step S4 was not performed, and the lower two samples are perovskite films in which the homogenization step S4 was performed. The upper two samples in which the homogenization step S4 was not performed have a lighter color and more unevenness than the lower two samples in which the homogenization step S4 was performed. That is, the upper two samples in which the homogenization step S4 was not performed have a lower quality than the lower two samples in which the homogenization step S4 was performed.

In the homogenization step S4, as shown in FIG. 8, the liquid pool 8a formed in the coating film 8 may be removed before the substrate 3 with the coating film 8 is held for a certain period of time. By removing the liquid pool 8a, unevenness of the coating film 8 can be further suppressed.

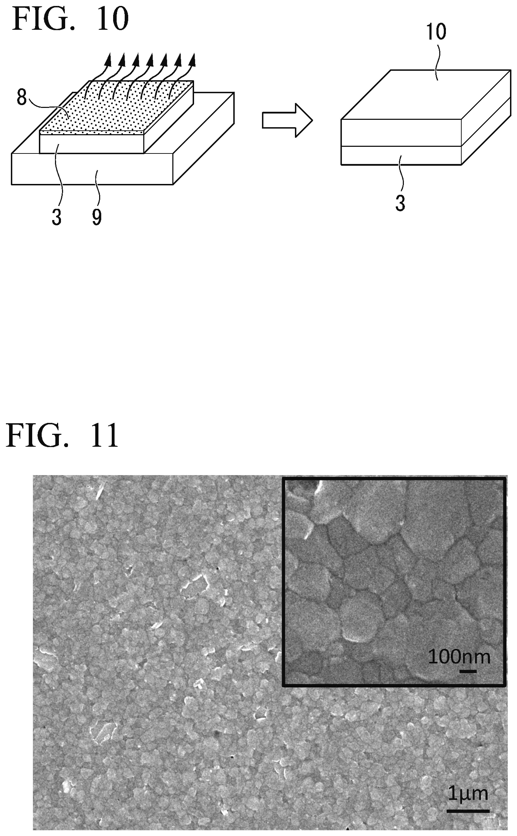

FIG. 10 is a schematic view for describing an annealing step S5 of the method for producing a perovskite film according to the present embodiment. In the annealing step, the coating film 8 is annealed. For example, the coating film 8 is annealed by heating the substrate 3 with the coating film 8 with the heater 9. The annealing temperature is, for example, 100°C or higher, and the annealing time is, for example, 1 hour or longer. When the coating film 8 is annealed, the solvent is removed from the coating film 8, and the perovskite is crystallized to obtain a perovskite film 10.

The perovskite film 10 has a cubic crystal structure represented by a general formula ABX₃. Different atoms or molecules are disposed at the vertices (A sites) of the cube, the centers (X sites) of each face of the cube, and the center (B site) of the cube. For example, materials such as CH₃NH₃ and CH₅N₂ are used for the A site. For example, materials such as Pb, Sn, and Ge are used for the B site. For example, materials such as I, Cl, and Br are used for the X site. The perovskite film 10 is, for example, a perovskite film of CsFAMA (general formula: Cs_{0.05}(FA_{0.83}MA_{0.17})_{0.95}Pb(I_{0.83}Br_{0.17})₃).

The mixed solution preparation step S1, the base layer preparation step S2, the coating step S3, the homogenization step S4, and the annealing step S5 can be performed even when the film-forming atmosphere is air having a humidity of 40% or more. The perovskite film 10 is susceptible to moisture. Therefore, the perovskite film 10 is generally produced in an inert gas atmosphere such as nitrogen or argon. On the other hand, in the method for producing a perovskite film according to the present embodiment, the hydrophobicity of the perovskite film is improved by adding the ionic liquid 2 to the mixed solution. In addition, in the perovskite film by the bar coating method, the rapid volatilization of the solvent is suppressed, and the film quality of the produced perovskite film 10 can be improved. As a result, the perovskite film 10 can be appropriately produced even under the film formation conditions of an atmosphere with a humidity of 40% or more.

The method for producing a perovskite film according to the present embodiment is performed using a coating method that is easily applied to a roll-to-roll method such as a bar coating method. In the spin coating method, a perovskite film can be formed only by a sheet-fed method. In the roll-to-roll method, it is easier to increase the area than in the sheet-fed spin coating method, and the process cost is also lower.

The perovskite film 10 according to the present embodiment has high durability. This is considered to be because moisture is less likely to enter the perovskite film 10.

In the perovskite film 10 according to the present embodiment, the size of the grains G is large, and the number of grain boundaries between the grains G is small.

FIG. 11 is a scanning electron microscope image of a perovskite film according to a first comparative example. The first comparative example is different from the method for producing a perovskite film according to the present embodiment in that the coating film 8 is formed by a spin coating method. In the perovskite film according to the first comparative example, the modal grain size of the grains is 1 µm or less. In the perovskite film according to the first comparative example, the size of the grains is smaller than that of the perovskite film 10 according to the present embodiment, and the number of grain boundaries of the grains is larger.

Moisture (H₂O) enters from the grain boundaries of the grains G constituting the perovskite film 10. In the perovskite film 10 according to the present embodiment, since the size of the grains G is large, the number of grain boundaries between the grains G is small, and the number of paths for moisture to enter is small.

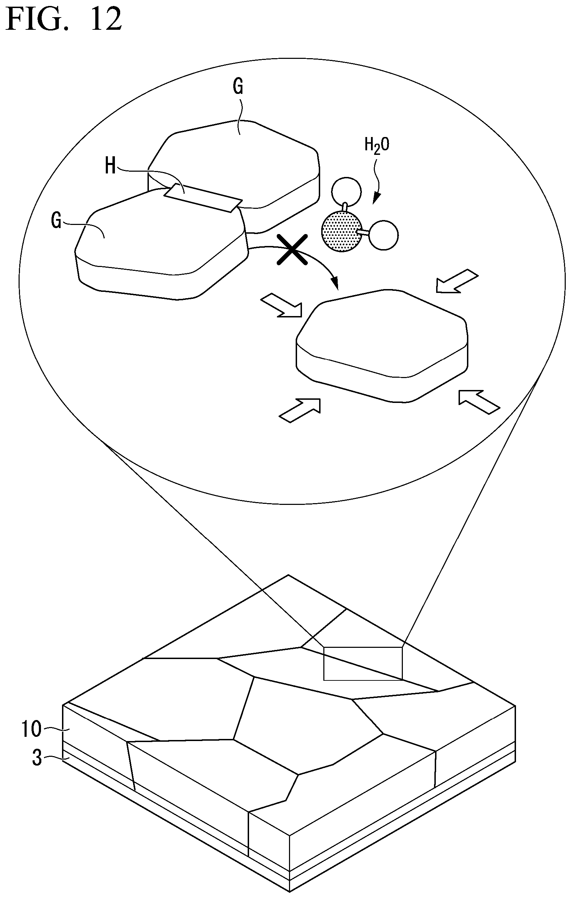

In addition, the use of the ionic liquid in the production of the perovskite film 10 according to the present embodiment is one of the factors that increase the durability of the perovskite film 10. FIG. 12 is a schematic view for describing one of the reasons why the durability of the perovskite film 10 according to the present embodiment is high.

As shown in FIG. 12, when the grain boundaries of at least a plurality of grains G contain the hydrophobic functional group H, the hydrophobic functional group H repels moisture, and prevents the water from entering the grain boundaries of the grains G. A part of the ionic liquid is N-H-bonded to the perovskite and functions as the hydrophobic functional group H. The hydrophobic functional group H of the ionic liquid 2 is exposed at least at the grain boundaries of the grains G. Since the hydrophobic functional group H has low affinity for water, the hydrophobic functional group H prevents the water from entering the grain boundaries of the grains G.

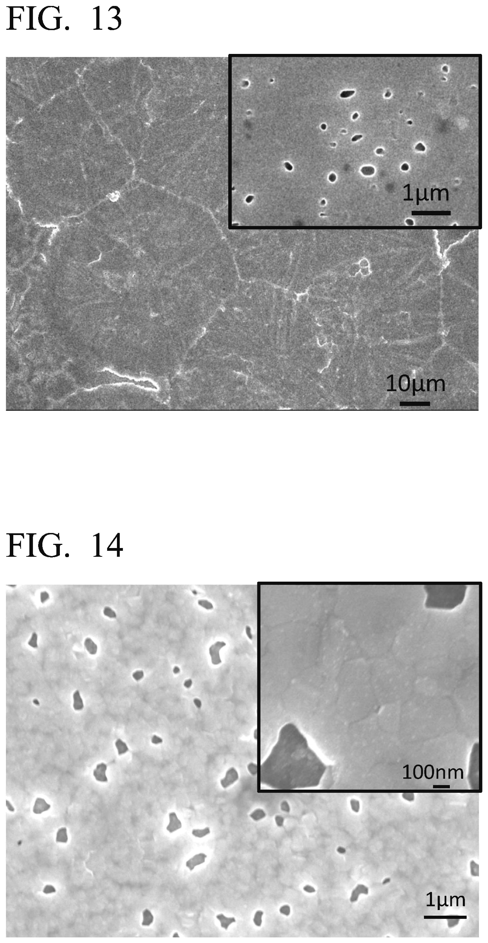

FIG. 13 is a scanning electron microscope image of a perovskite film according to a second comparative example. FIG. 14 is a scanning electron microscope image of a perovskite film according to a third comparative example. The second comparative example is different from the perovskite film according to the present embodiment in that the ionic liquid is not used. The third comparative example is different from the perovskite film according to the first comparative example in that the ionic liquid is not used.

As shown in FIGS. 13 and 14, in a case where the ionic liquid is not used, pinholes are generated in the perovskite film. The pinholes serve as a pathway for intrusion of moisture, and reduce the durability of the perovskite film. That is, the fact that the ionic liquid is used in the method for producing the perovskite film 10 according to the present embodiment is also one of the reasons for increasing the durability of the perovskite film 10.

As shown in FIGS. 13 and 14, even in a case where the ionic liquid is not used, a difference in grain size due to a difference in coating method is confirmed.

The perovskite film according to the present embodiment can be applied to various elements such as a photoelectric conversion element, a piezoelectric conversion element, and a thermoelectric conversion element. Hereinafter, an example in which the perovskite film is used for a thin film solar cell will be described as an example of an application example of the perovskite film.

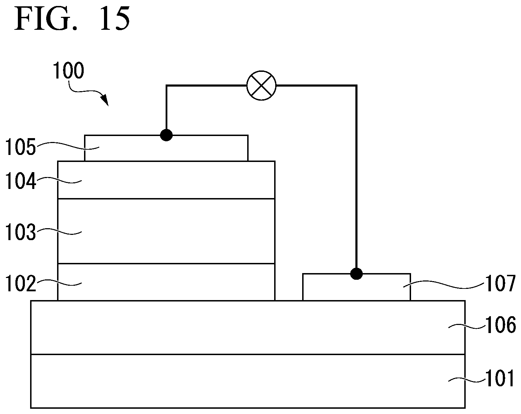

FIG. 15 is a side view of a thin film solar cell 100 according to the present embodiment. The thin film solar cell 100 includes a substrate 101, an electron transport layer 102, a power generation layer 103, a hole transport layer 104, an electrode layer 105, an electrode layer 106, and an electrode layer 107. The electrode layer 105 is a positive electrode layer, and the electrode layer 106 and the electrode layer 107 are negative electrode layers. In FIG. 15, the electron transport layer 102, the power generation layer 103, and the hole transport layer 104 are sequentially laminated on the substrate 101. The positional relationship between the electron transport layer 102 and the hole transport layer 104 may be reversed.

The substrate 101 is not particularly limited as long as the substrate 101 supports a structure consisting of the above-described layers. The substrate 101 is preferably a transparent conductive substrate having excellent light transmittance, and for example, more preferably a transparent conductive substrate having a transmittance of visible light of 90% or more. In addition, the substrate 101 is preferably flexible. Examples of a constituent material of the substrate 101 include glass and a plastic film. As a resin constituting the plastic film, for example, polyethylene terephthalate, polyethylene naphthalate, or the like can be used.

The electrode layer 106 is, for example, a transparent electrode. The electrode layer 106 is on the substrate 101. A known material can be applied as the electrode layer 106. The electrode layer 106 is, for example, a conductive transparent oxide film, graphene, a carbon nanotube, or a conductive polymer film. The conductive transparent oxide is, for example, fluorine-doped tin oxide (FTO), indium tin oxide (ITO), indium zinc oxide (IZO), zinc oxide, tin oxide, titanium oxide, or the like.

The electron transport layer 102 is a layer that collects electrons generated in the power generation layer 103 and efficiently transports the electrons toward the electrode layer 106. Examples of a constituent material of the electron transport layer 102 include an n-type semiconductor such as an inorganic material such as zinc oxide, titanium oxide, tin oxide, niobium oxide, or aluminum oxide, or an organic material such as PCBM or fullerene C₆₀.

The power generation layer 103 is a layer (photoelectric conversion layer) that generates power by receiving light. The power generation layer 103 is composed of a material having a perovskite structure. The above-described perovskite film 10 can be applied to the power generation layer 103.

The hole transport layer 104 is a layer that collects holes generated in the power generation layer 103 and efficiently transports the holes toward the electrode layer 105. Examples of a constituent material of the hole transport layer 104 include a p-type semiconductor such as an inorganic material such as nickel oxide, copper iodide, copper oxide, or copper sulfide, or an organic material such as Spiro-OMeTAD, PTAA, or PEDOT:PSS (a composite of poly(3,4-ethylenedioxythiophene) (PEDOT) and polystyrenesulfonic acid (PSS)).

The electrode layers 105 and 107 are each composed of, for example, a metal such as gold, silver, or aluminum, or a conductive material such as an organic conductive ink such as PEDOT:PSS.

The thin film solar cell 100 according to the present embodiment is obtained by sequentially laminating each layer constituting the thin film solar cell 100.

For example, first, the substrate 101 on which the electrode layer 106 is formed is prepared. For example, the electrode layer 106 is FTO, and the substrate 101 is glass. A commercially available product may be purchased as the substrate 101 with the electrode layer 106.

Next, the substrate 101 with the electrode layer 106 is subjected to ultrasonic cleaning and plasma treatment, and then the electron transport layer 102 is formed on one surface of the electrode layer 106. The electron transport layer 102 is obtained, for example, by sequentially forming a dense TiO₂ layer and a TiO₂ nanoparticle layer by spin coating. Each layer is obtained by repeating spin coating and annealing a plurality of times. The electron transport layer 102 corresponds to the base layer in the above-described method for producing a perovskite film.

Next, the surface of the electron transport layer 102 is subjected to plasma treatment. The plasma treatment corresponds to the plasma treatment on the base layer in the above-described method for producing a perovskite film.

The power generation layer 103 is formed on the surface of the plasma-treated electron transport layer 102 by a predetermined coating method. The predetermined coating method is a coating method used in the above-described method for producing a perovskite film. The predetermined coating method is, for example, a bar coating method. The power generation layer 103 is a perovskite film, and the power generation layer 103 is formed according to the above-described method for producing a perovskite film.

The hole transport layer 104 is formed on one surface of the power generation layer 103. For example, Spiro-OMeTAD is spin-coated as the hole transport layer 104.

Next, a part of the electron transport layer 102, the power generation layer 103, and the hole transport layer 104 is cut out, and the electrode layers 105 and 107 are formed thereon. The electrode layers 105 and 107 are, for example, gold, and can be formed by vapor deposition. A thin film solar cell according to the present embodiment can be produced by such a procedure.

The thin film solar cell according to the present embodiment has excellent output characteristics and durability. The reason why the thin film solar cell according to the present embodiment has excellent durability is that the durability of the perovskite film constituting the power generation layer 103 is high, as described above.

In addition, the reason why the output characteristics of the thin film solar cell according to the present embodiment are excellent is considered to be that the grains of the power generation layer 103 are large.

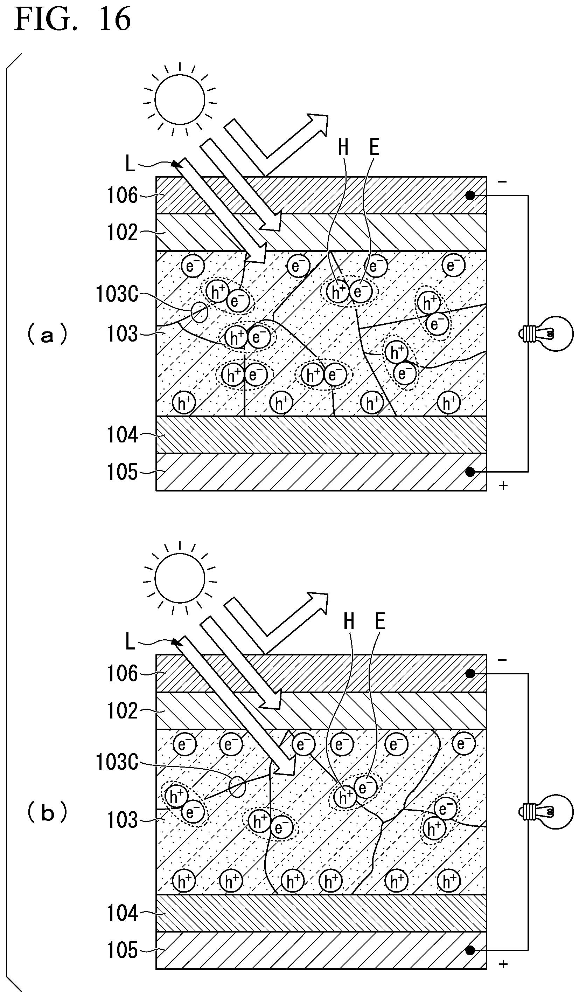

FIG. 16 is a schematic diagram for describing characteristics of the thin film solar cell according to the present embodiment. FIG. 16(a) shows a configuration of a thin film solar cell of a first comparative example, which is a thin film solar cell in which the power generation layer 103 is produced by a spin coating method. FIG. 16(b) shows a configuration of a thin film solar cell according to the present embodiment, which is a thin film solar cell in which the power generation layer 103 is produced by a bar coating method. The crystal grain size (grain size) of the power generation layer 103 (FIG. 16(b)) of the present embodiment is larger than a crystal grain size (grain size) of the power generation layer 103 (FIG. 16(a)) produced by the spin coating method.

By irradiation with sunlight L or the like, electrons E and holes H generated in the power generation layer 103 flow toward the electrode layer 106 and the electrode layer 105, respectively, but a part of the electrons E and the holes H are trapped at crystal grain boundaries 103C present in the flow path. Since the trapped electrons E and holes H recombine, the number of electrons E reaching the electrode layer 106 and the number of holes H reaching the electrode layer 105 are reduced, and a loss of the output current occurs by the reduction. In the power generation layer 103 of the present embodiment shown in FIG. 16(b), the crystal grain size is large, and the distribution density (volume density) of the crystal grain boundaries 103C is low. Therefore, in the power generation layer 103 of the present embodiment, the number of carriers trapped and recombined at the crystal grain boundaries 103C is small. As the number of carriers that reach the electrode without recombination increases, the output current increases, and the output characteristics (PCE) of the thin film solar cell are improved.

Although the preferred embodiments of the present disclosure have been described in detail above, the present disclosure is not limited to the specific embodiments, and various modifications and changes can be made within the scope of the gist of the present disclosure as described in the claims.

### Examples

### (First Example)

In the first example, each configuration shown in FIG. 15 was used to produce the following thin film solar cell.
Substrate 101: glass
Electrode layer 106: FTO
Electron transport layer 102: TiO₂
Power generation layer 103: Cs_{0.05}(FA_{0.83}MA_{0.17})_{0.95}Pb(I_{0.83}Br_{0.17})₃
Hole transport layer 104: Spiro-OMeTAD
Electrode layers 105 and 107: gold

The power generation layer 103 of the first example was produced by applying, by a bar coating method, a mixed solution obtained by mixing a first solution to which an ionic liquid was added at a mass ratio of 3 wt% and a second solution to which an ionic liquid was not added and annealing the mixed solution.

The ionic liquid was 1-hexyl-3-methylimidazolium chloride (HMImCl). The perovskite precursors contained in the first solution were CH₃NH₃I and PbI₂, and the solvent was dimethylformamide (DMF). The perovskite precursors contained in the second solution were CH₄N₂HI, PbI₂, PbBr₂, and CsI, and the solvent was a mixed solvent of dimethylformamide (DMF) and dimethyl sulfoxide (DMSO). 200 µl of the first solution and 373 µl of the second solution were taken out and mixed to obtain a mixed solution containing Cs_{0.05}(FA_{0.83}MA_{0.17})_{0.95}Pb(I_{0.83}Br_{0.17})₃. The mass ratio of the ionic liquid in the mixed solution was 0.5 wt%.

Before applying the mixed solution by the bar coating method, the surface of the electron transport layer 102 was subjected to an oxygen plasma treatment. The plasma treatment was performed at room temperature for 20 minutes under conditions of 115 V, 18 W, and a degree of vacuum of 0.1 MPa. In addition, after applying the mixed solution by the bar coating method, a standing time of 5 minutes was secured as a homogenization step. The coating film was annealed at 100°C for 1 hour. The power generation layer 103 was produced in an atmosphere having a humidity of 40% or more.

### (Second Example)

The second example is different from the first example in that the plasma treatment on the surface of the electron transport layer 102 and the standing step in producing the power generation layer were not performed. Other conditions were the same as those in the first example.

FIG. 9 described above is a comparison result between the first example and the second example. As shown in FIG. 9, the power generation layer according to the first example (the lower two samples in FIG. 9) was more uniform and less uneven than the power generation layer according to the second example (the upper two samples in FIG. 9).

### (First Comparative Example)

The first comparative example is different from the first example in that the power generation layer 103 was produced by a two-step spin coating method. A thin film solar cell was produced under the other conditions the same as those in the first example.

First, in a first step, a solution obtained by adding an ionic liquid to a perovskite precursor solution was spin-coated. A mass ratio of the ionic liquid in this case was, for example, 1 wt%. Next, in a second step, a solution containing CsFAMA perovskite was spin-coated. Then, the coated layer was annealed at 100°C for 1 hour.

### (Second Comparative Example)

The second comparative example is different from the first example in that an ionic liquid was not used in producing the power generation layer 103. A thin film solar cell was produced under the other conditions the same as those in the first example.

### (Third Comparative Example)

The third comparative example is different from the first comparative example in that an ionic liquid was not used in producing the power generation layer 103. A thin film solar cell was produced under the other conditions the same as those in the first comparative example.

SEM images of surfaces of the power generation layers of the first example, the first comparative example, the second comparative example, and the third comparative example were observed. The power generation layer of the first example corresponds to FIG. 1. The power generation layer of the first comparative example corresponds to FIG. 11. The power generation layer of the second comparative example corresponds to FIG. 13. The power generation layer of the third comparative example corresponds to FIG. 14.

In the second comparative example and the third comparative example in which the ionic liquid was not used, pinholes were formed in the power generation layer 103. In addition, the sizes of the grains of the power generation layers 103 of the first example and the second comparative example produced by the bar coating method were larger than the sizes of the grains of the power generation layers 103 of the first comparative example and the third comparative example produced by the spin coating method.

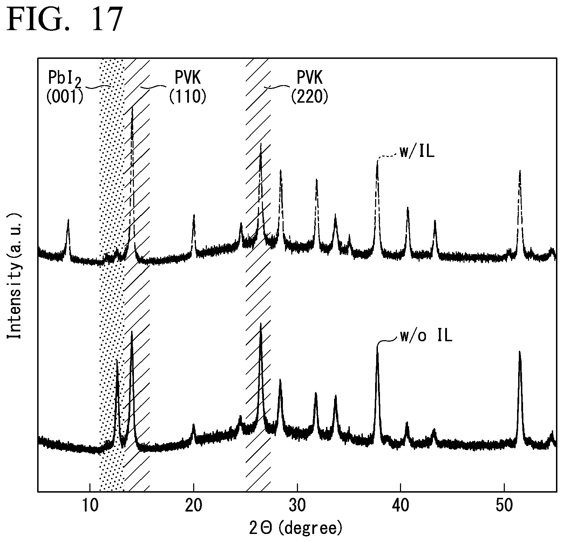

In addition, FIG. 17 shows the measurement results of X-ray diffraction (XRD) of the power generation layers of the first example and the second comparative example. In FIG. 17, "w/IL" indicates that an ionic liquid was used, and corresponds to the result of the first example. In FIG. 17, "w/o IL" indicates that an ionic liquid was not used, and corresponds to the result of the second comparative example. As shown in FIG. 17, in the second comparative example in which the ionic liquid was not used, a peak due to PbI₂ was confirmed in the vicinity of 2θ = 13°. PbI₂ is a decomposition product of perovskite. That is, it can be seen that the film quality of the power generation layer according to the first example is superior to the film quality of the power generation layer according to the second comparative example.

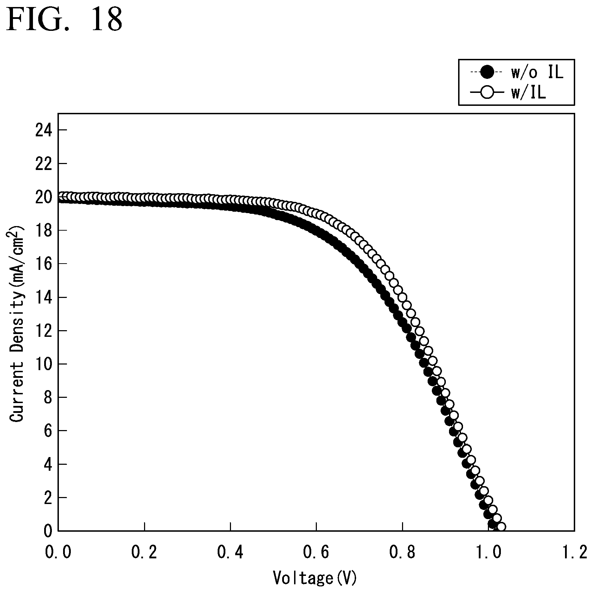

In addition, FIG. 18 shows the characteristics of the thin film solar cells of the first example and the second comparative example. In FIG. 18, "w/IL" indicates that an ionic liquid was used, and corresponds to the result of the first example. In FIG. 18, "w/o IL" indicates that an ionic liquid was not used, and corresponds to the result of the second comparative example. As shown in FIG. 18, the output characteristics (PCE) of the thin film solar cell of the first example were superior to those of the second comparative example.

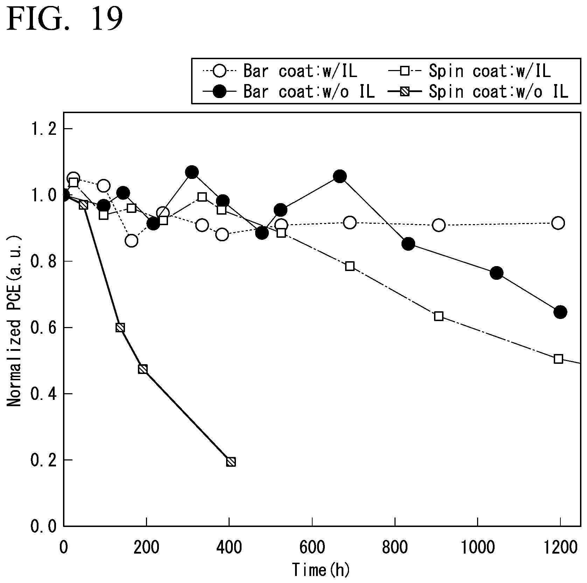

In addition, FIG. 19 shows the results of measuring the durability of the thin film solar cells using the perovskite films of the first example, the first comparative example, the second comparative example, and the third comparative example. In FIG. 19, "Bar coat w/IL" indicates that the power generation layer was formed by a bar coating method using an ionic liquid, and corresponds to the result of the first example. "Bar coat w/o IL" indicates that the power generation layer was formed by a bar coating method without using an ionic liquid, and corresponds to the result of the second comparative example. "Spin coat w/IL" indicates that the power generation layer was formed by a spin coating method using an ionic liquid, and corresponds to the result of the first comparative example. "Spin coat w/o IL" indicates that the power generation layer was formed by a spin coating method without using an ionic liquid, and corresponds to the result of the third comparative example. The horizontal axis of FIG. 19 indicates the operating time of the thin film solar cell, and the vertical axis of FIG. 19 indicates the change in PCE when the initial PCE of the thin film solar cell is normalized to 1. The PCE in the durability test was obtained by leaving the unsealed device in the dark in the atmosphere with a relative humidity (RH) of 40% or more and 70% or less, and performing the I-V measurement under simulated sunlight every approximately one week.

As shown in FIG. 19, the thin film solar cells according to the first example and the second comparative example, which were produced by the bar coating method, had more excellent durability than the thin film solar cells according to the first comparative example and the third comparative example, which were produced by the spin coating method. This is considered to be because the grain size of the power generation layer was increased and the spaces between grains where water infiltrates were reduced by using the bar coating method. In addition, the first example including the ionic liquid had more excellent durability of the solar cell than the second comparative example not including the ionic liquid. This is considered to be because pinholes were less likely to be formed in the power generation layer by including the ionic liquid, and the hydrophobic group of the ionic liquid prevented the infiltration of water.

### (Third Example to Sixth Example)

The third example to the sixth example are different from the first example in that the concentration of the ionic liquid in forming the power generation layer was changed. The thin film solar cell was produced under the same conditions as in the first example, except for the above-described conditions. In each of the third example to the sixth example, the mass ratio of the ionic liquid in the first solution and the mass ratio of the ionic liquid in the mixed solution are as follows. In addition, for comparison, the mass ratio of the ionic liquid in the second comparative example and the first example is also shown below.

### Second Comparative Example

Mass ratio of ionic liquid in first solution 0 wt%
Mass ratio of ionic liquid in mixed solution 0 wt%

### Third Example

Mass ratio of ionic liquid in first solution 1 wt%
Mass ratio of ionic liquid in mixed solution 0.17 wt%

### First Example

Mass ratio of ionic liquid in first solution 3 wt%
Mass ratio of ionic liquid in mixed solution 0.5 wt%

### Fourth Example

Mass ratio of ionic liquid in first solution 5 wt%
Mass ratio of ionic liquid in mixed solution 0.83 wt%

### Fifth Example

Mass ratio of ionic liquid in first solution 7 wt%
Mass ratio of ionic liquid in mixed solution 1.17 wt%

### Sixth Example

Mass ratio of ionic liquid in first solution 10 wt%
Mass ratio of ionic liquid in mixed solution 1.66 wt%

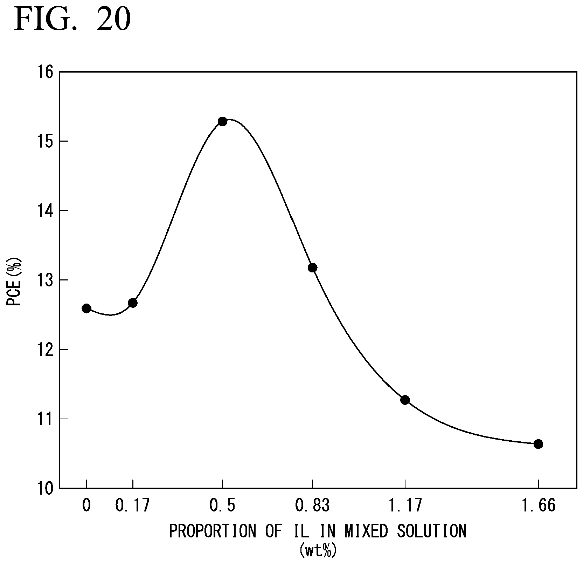

FIG. 20 shows the output characteristics (PCE) of the thin film solar cells of the first example, the third example to the sixth example, and the second comparative example. The specific values of PCE in each of the examples and comparative examples were as follows.
Second comparative example: 12.59%
Third example: 12.67%
First example: 15.28%
Fourth example: 13.18%
Fifth example: 11.27%
Sixth example: 10.64%

As shown in FIG. 19, it was confirmed that the output characteristics of the thin film solar cell were improved most in a case where the mass ratio of the ionic liquid in the first solution was 3 wt% (the mass ratio of the ionic liquid in the mixed solution was 0.5 wt%).

### REFERENCE SIGNS LIST

1 Perovskite precursor solution
2 Ionic liquid
3 Substrate
4 Mixed solution
5 Dummy substrate
6 Bar
7 Support body
8 Coating film
9 Heater
10 Perovskite film
100 Thin film solar cell
101 Substrate
102 Electron transport layer
103 Power generation layer
103C Crystal grain boundary
104 Hole transport layer
105, 106, 107 Electrode layer
G Grain
H Hydrophobic functional group
S1 Mixed solution preparation step
S2 Base layer preparation step
S3 Coating step
S4 Homogenization step
S5 Annealing step

## Claims

1. A perovskite film having a plurality of grains when viewed in plan from a stacking direction,
wherein a modal grain size of the plurality of grains is 1 µm or more.

2. The perovskite film according to Claim 1,
wherein the perovskite film has a hydrophobic functional group, and the hydrophobic functional group is present at least at grain boundaries of the plurality of grains.

3. The perovskite film according to Claim 2,
wherein the hydrophobic functional group is a hydrophobic group derived from an ionic liquid.

4. The perovskite film according to Claim 1,
wherein the perovskite film has holes observable when viewed in plan from the stacking direction, and
an average density of the holes is 0.2 holes/µm² or less.

5. A thin film solar cell comprising:
the perovskite film according to Claim 1 as a power generation layer.

6. A method for producing a perovskite film, the method comprising:
a step of preparing a mixed solution by adding an ionic liquid to a perovskite precursor solution;
a step of applying the mixed solution onto a base layer by bar coating, blade coating, slot die coating, spray coating, gravure coating, reverse coating, or comma coating to form a coating film; and
a step of annealing the coating film.

7. The method for producing a perovskite film according to Claim 6,
wherein the coating film is annealed after 5 minutes or more have elapsed from formation of the coating film.

8. The method for producing a perovskite film according to Claim 6,
wherein a surface of the base layer is subjected to a plasma treatment before the coating film is formed.

9. The method for producing a perovskite film according to Claim 6,
wherein a film-forming atmosphere is air having a humidity of 40% or more.

10. The method for producing a perovskite film according to Claim 6,
wherein a mass ratio of the ionic liquid in the mixed solution is 0.17 wt% or more and 0.83 wt% or less.

11. A method for producing a thin film solar cell, the method comprising:
forming a power generation layer having a perovskite structure using the method for producing a perovskite film according to Claim 6.
